# EUROPEAN PATENT SPECIFICATION

(11) **EP 2 076 990 B1**
(45) Date of publication and mention of the grant of the patent: **12.12.2018**
(21) Application number: 07852862.7
(22) Date of filing: 19.10.2007
(51) Int. Cl.: H04L 1/00, B60C 23/04

(54) **METHOD FOR DETECTING AND CORRECTING DATA ERRORS IN AN RF DATA LINK**
VERFAHREN ZUM DETEKTIEREN UND KORRIGIEREN VON DATENFEHLERN IN EINER HF-DATENVERBINDUNG
PROCÉDÉ POUR DÉTECTER ET CORRIGER DES ERREURS DE DONNÉES DANS UN LIEN DE DONNÉES RF

(30) Priority: 20.10.2006 US 584244
(43) Date of publication of application: 08.07.2009
(73) Proprietor: Schrader Electronics Limited, Antrim BT41 1QS (GB)
(72) Inventor: REID, Ivan, Belfast, N. Ireland BT6 9ET (GB); MACKEL, Peter, Belfast, N. Ireland BT9 6SQ (GB); CASKEY, David, Magherafelt, N. Ireland BT45 6QG (GB)
(74) Representative: FRKelly
(86) International application number: PCT/US2007/022324
(87) International publication number: WO 2008/127294

(56) References cited:
- WO-A-2005/116603
- US-A- 5 170 396
- US-A- 5 701 329
- US-A1- 2002 044 050

## Description

### BACKGROUND OF THE INVENTION

### Field of the Invention

The present invention relates to RF data links in which data is sent from one or more RF transmitters to one or more RF receivers in a data format utilizing data frames and blocks. More particularly, this invention pertains to methods of improving the quality of data sent across an RF data link as used in a remote tire pressure monitoring systems and the like.

### Description of the Prior Art

Remote tire pressure monitoring systems (TPMS) are used in motor vehicles to provide accurate tire pressure information to the driver in real time. A typical TPMS will have a pressure sensor mounted in each wheel, with an RF transmitter coupled to each sensor. The transmitter receives pressure data from its corresponding sensor and sends the data to a receiver. The receiver is under the control of a processor which then decodes the data and communicates the tire pressure information to the driver.

Preferably, the RF data link between the transmitter and receiver is configured to send digital data. Thus, each RF signal is formatted as a data frame. Each frame of data transmitted by a wheel sensor/transmitter in a remote tire pressure monitoring system includes a sequence of bits sometimes referred to as a data record, word or character. The frame may contain information corresponding to the tire/wheel identifier which uniquely identifies the sensor/transmitter combination, and tire data, such as data corresponding to the measured tire pressure of the tire. This data is sometimes referred to as the "payload." Other information, such as a frame header or synchronization data may be transmitted as part of the frame. Multiple frames of data forming a data block may be transmitted during respective time periods. For example, a data block may contain eight frames of data sent during eight time periods. Data blocks are preferably repeated in the TPMS at an update frequency. The update frequency may be selected to be on the order of seconds, minutes or hours, or any other suitable rate. Also, the update frequency may be varied depending on the mode of operation such as when the wheel is stationary or rolling.
A frame or block of data is conventionally subjected to some type of error detection by the processor in the TPMS. For example, a checksum step is a basic error- detection technique in which each transmitted frame or block includes a numerical value based on a number of set bits in the frame or block as determined by a checksum algorithm (e.g., CRC) in the transmitter. The receiver then applies the same checksum algorithm to the received frame or block to determine if the numerical value calculated from the received data matches the transmitted numerical value. If it does not, the processor can assume that the received data has been corrupted.
The RF data link in a TPMS must operate in a harsh environment that is electrically noisy. The strength of the transmitted signal can be degraded by ambient conditions. Accordingly, it is common for the transmitted data to be corrupted or garbled. Data bits can be dropped or incorrectly sent, resulting in invalid data, no data, and/or slow processing time at the receiving end. Certain invalid data is sometimes referred to as "implausible" because its value falls outside a range of what could reasonably be expected during normal operation of the system.
Attempts have been made in the prior art to improve the quality of the RF data link in TPMS. These have included hardware changes to either the TPMS wheel transmitter or TPMS receiver to improve the RF signal quality of the RF link itself. Other efforts have focused on providing more protection in the transmitter against spurious readings of temperature and pressure (EMC, ASIC filtering, etc). Unfortunately, these solutions have not been entirely satisfactory and any solution that adds hardware to the system will increase the cost of the system.

### SUMMARY

The present invention is directed to systems and methods which provide robust reconstruction of wireless transmission data frames and blocks, such as TPMS frames and blocks, that have been corrupted as a result of poor quality of received RF data. Preferably the present methods and systems are implemented in or though software, firmware or, other programmable mediums. A further data filtering algorithm may also be employed on the information contained in the frames and blocks. These software algorithms help to insure that the information received is plausible and consistent with the information transmitted.

US5701329 discloses a mobile radio station that uses a cumulative majority vote procedure to provide a higher probability of correct reception of a message addressed to the receiving station. US5701396 discloses a data valid detector for Manchester encoded data that monitors the location and number of edges in one bit period, and the output count of an integrator type Manchester decoder circuit. US2002044050 discloses a tire condition monitoring system that uses Manchester encoded on-off keying to accommodate inaccuracies introduced by use of an RC oscillator; or proposes the use of a ceramic resonator in the wheel unit to increase the accuracy of data transmission.

The invention provides a method for correcting errors in a block of digital data as claimed in claim 1. In one embodiment, the method includes four basic steps or procedures. In a first step, the number of, and position of, any invalid bits in a transmitted data frame, such as a TPMS frame, is detected. To perform this step, when the RF data frame is being decoded, any invalid bits are detected using edge detection windows. The location and width of these windows are configurable in software. In order to ensure accurate timing, the software preferably resynchronizes on each bit. All the values of each bit, along with their validity status are preferably recorded and stored.

In a second step, the data frame (TPMS frame) is reconstructed using a CRC eight bit error validation technique, or the like. Using the information obtained from step one, the degree of data corruption can be determined. The software preferably allows for user configuration of an acceptable level of corruption. The data validity bits may then be used to simplify the reconstruction algorithm. Trial solutions may be reduced from 2M to 2N, where M is the total number of bits in the payload and checksum and N is the number of invalid bits in the payload and checksum. Other possible solutions may be determined by using previously known pressure and temperature ranges (also configurable in software). Then, software algorithms may be used to reconstruct the frame.

In a third step, the data block (TPMS data block) may be reconstructed. Using information obtained from valid and reconstructed frames, the correct information for the block may be deciphered. Further algorithms may be used to check for data consistency, majorities, plausibility, etc.

In a fourth step, the data may be filtered and verified. This is accomplished by comparing information stored from previous data blocks with the information from the current block information to insure plausibility of the data before using it, such as in TPMS application modules and publishing the information on a vehicle data bus.

Embodiments of methods of the present invention can be implemented purely in software, firmware, or the like, making it faster to implement and change. It is a less expensive alternative to a hardware changes. It is easily configurable merely through software changes, firmware updates, or the like. The method can be used in any RF data link that incorporates a robust checksum in the payload.

The foregoing has outlined rather broadly the features and technical advantages of the present invention in order that the detailed description of the invention that follows may be better understood. Additional features and advantages of the invention will be described hereinafter which form the subject of the claims of the invention. It should be appreciated by those skilled in the art that the conception and specific embodiment disclosed may be readily utilized as a basis for modifying or designing other structures for carrying out the same purposes of the present invention. It should also be realized by those skilled in the art that such equivalent constructions do not depart from the spirit and scope of the invention as set forth in the appended claims. The novel features which are believed to be characteristic of the invention, both as to its organization and method of operation, together with further objects and advantages will be better understood from the following description when considered in connection with the accompanying figures. It is to be expressly understood, however, that each of the figures is provided for the purpose of illustration and description only and is not intended as a definition of the limits of the present invention.

### BRIEF DESCRIPTION OF THE DRAWINGS

The accompanying drawings, which are incorporated in and form part of the specification in which like numerals designate like parts, illustrate embodiments of the present invention and together with the description, serve to explain the principles of the invention. In the drawings:
Figure 1 is a graphical representation of the preamble and payload portions of one example of a TPMS or similar data frame;
Figure 2 is a graphical representation of an RF data line from a TPMS receiver or the like, with no RF activity from a (TPMS) transmitter;
Figure 3 a graphical representation of an RF data line from a TPMS receiver or the like, with RF activity from the (TPMS) transmitter and further showing a triggering of an RF mark detect line;
Figure 4 is a graphical representation of Manchester encoded zero and one bits;
Figure 5 is a graphical representation of an edge detection window opened inside a Manchester encoded bit to enable sampling of the RF data line during the time period within the edges of the window;
Figure 6 is a high level activity diagram showing the decoding and error correcting of data frames and blocks in accordance with an embodiment of a method of the present invention;
Figure 7 is an activity diagram of the frame decoding steps used in the method of Figure 6;
Figure 8 is an activity diagram showing the procedure to validate the first part of a data frame preamble as used in the method of Figures 6 and 7;
Figure 9 is an activity diagram showing calculation of the data bit time as used in the method of Figures 6-8;
Figure 10 is a flow chart showing decoding of Manchester encoded data bits as used in the method of the present invention;
Figure 11 is an activity diagram showing the frame reconstruction procedure as used in the method of the present invention;
Figure 12 is a high level sequence diagram of an embodiment of RF data frame and block decoding and error correction method of the present invention, as shown in Figure 6.;
Figure 13 is sequence diagram showing an embodiment of a procedure to validate a first part of a data frame preamble, as used in the method of Figures 6 and 7;
Figure 14 is a sequence diagram of the bit time calculation procedure used in embodiments of methods of the present invention and as shown in Figure 9;
Figure 15 is a sequence diagram of the Manchester bit decoding procedure as used in embodiments of methods of the present invention and as shown in Figure 10; and
Figure 16 is graph showing, by way of example, TPMS data frame processing time as a function of the maximum number of invalid bits in the frame.

### DETAILED DESCRIPTION

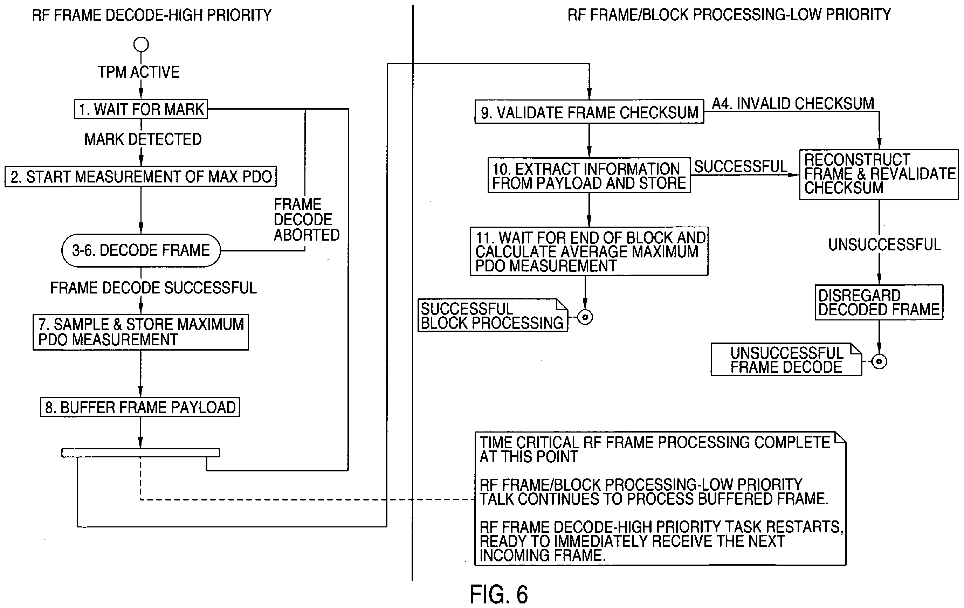

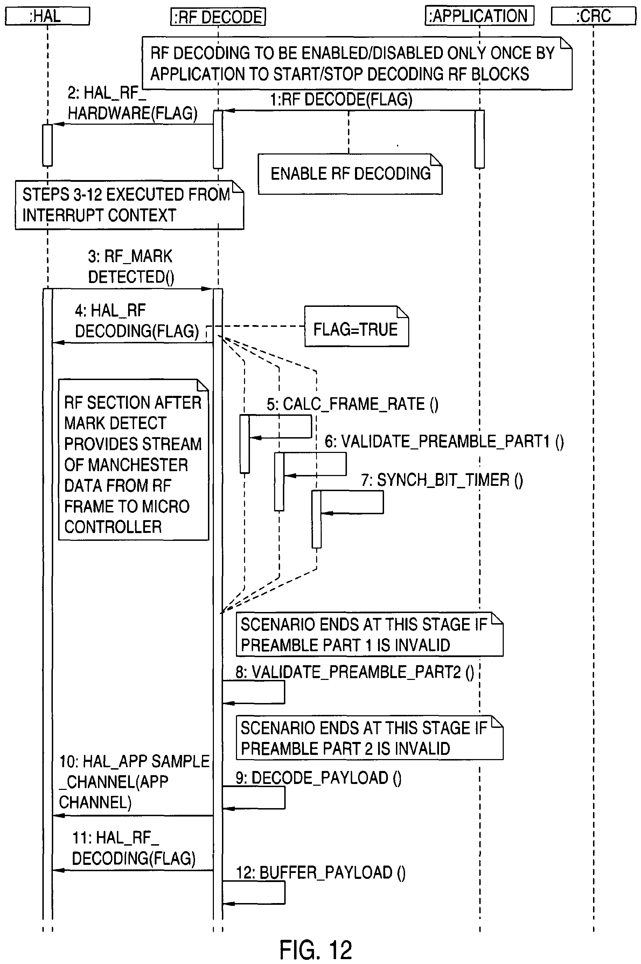

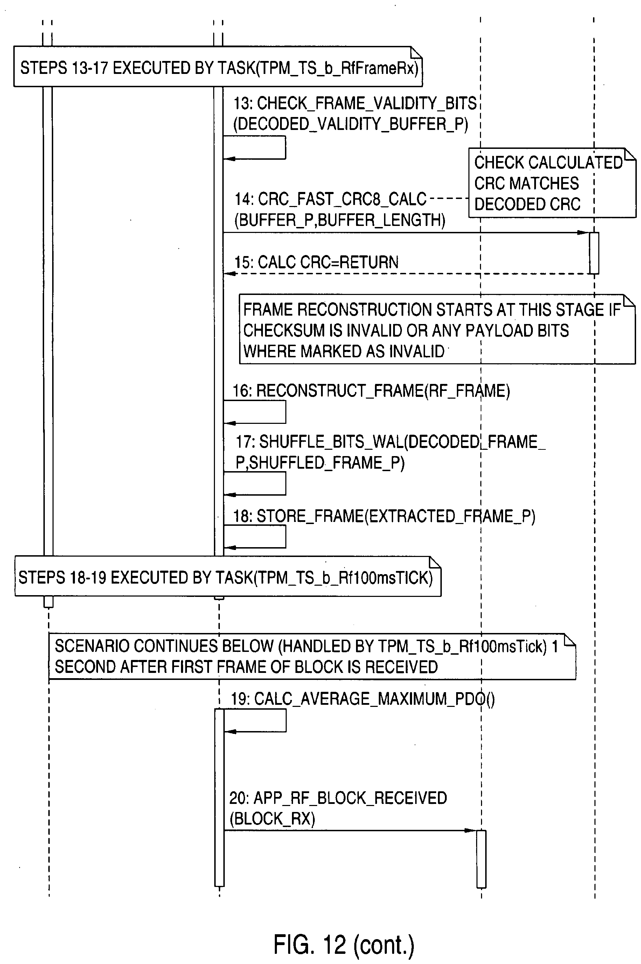

The steps and procedures of method embodiments generally described below are characterized in the flow charts shown in Figures 6-15. Figure 6 is a flow chart and Figure 12 is a sequence diagram illustrating at a high level the basic steps of an embodiment of a method of the present invention, which are preferably implemented in software, firmware, or other programmable medium. Embodiments of methods of the present invention are herein described with respect to a TPMS RF signal represented by a data frame and blocks. However, embodiments of the present invention may be employed with any number of RF signals employing data frames and blocks.

As detailed below, various embodiments of the present invention may include a number of steps including the following. Manchester encoded data frames or the like are received over a wireless link, such as may be provided in a TPMS and wherein the data frames have checksums and are comprised of symbols, the symbols each having a symbol period. Errors in the received data frames my be detected by determining whether each symbol is present in the received data frame, wherein each data error has a location in the received data frame and the presence of each symbol is detected by utilizing edge detection windows having a duration of one symbol period. The symbols in the received data frame may be marked as data errors if the edge detection window closes without a symbol being detected. The location of each data error may be stored in a system memory. Data frames may be discarded if the number of data errors exceeds a programmable threshold level. It may be determined if the data frames are correctable by utilizing a data correction algorithm, such as a cyclic redundancy check algorithm, wherein the data correction algorithm recalls and changes only the data errors in an attempt to satisfy the checksum so that the number of iterations used by the data correction algorithm in attempting to satisfy the checksum is reduced by not attempting iterations with changes to known good data. All modified data frames that satisfy the checksum may be stored to the system memory. In accordance with some embodiments of the present invention if the number of data errors exceeds a fixed number, such as four data errors, the received data frames may be discarded. The received data frames may be corrected if only one modified data frame satisfies the checksum. All other remaining data frames may be discarded as uncorrectable. Finally, the corrected data frames may be validated against programmable boundary thresholds.

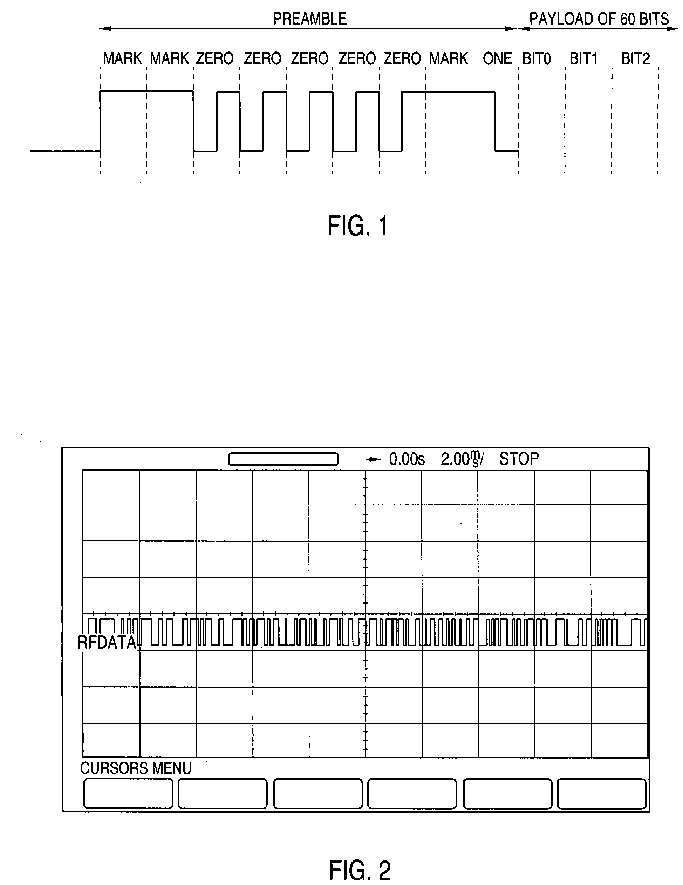

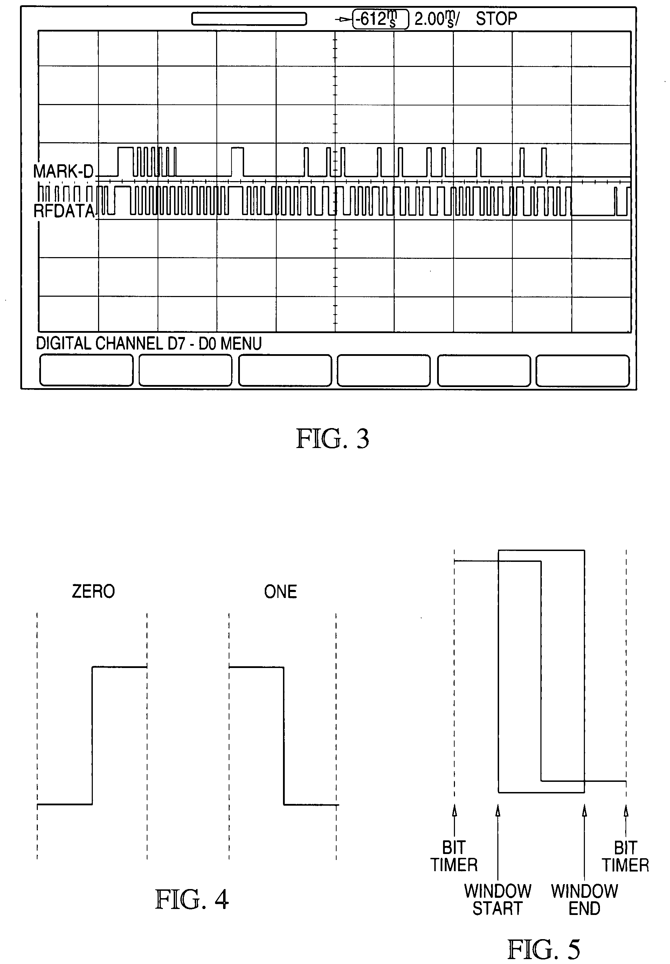

As illustrated in Figure 1, a TPMS RF data frame comprises a sequence of symbols or bits defining a preamble followed by a payload of M bits or symbols. The first step in decoding the RF data is to detect the start of a frame so that the TPMS processor can prepare itself to decode the entire frame. Figure 2 shows a received RF data line with no RF activity by the TPMS transmitter. As can be seen, the RF section in the TPMS receiver is constantly picking up noise. Because of this, it would be impossible for the TPMS processor to monitor every pulse on the RF data input line for the correct pulse width. Thus, in accordance with the present invention system hardware (e.g., in the vehicle Electronic Control Unit) preferably supplies a mark detect circuit that will trigger on detecting the correct pulse width and power level for a double mark. Figure 3 shows a received RF data line with TPMS transmitter RF activity. Figure 3 also shows triggering of the RF mark detect line. Because the TPMS processor is not constantly processing noise in the received RF data line searching for the start of a RF frame, the processing load on the TPMS processor and/or similar equipment is decreased.

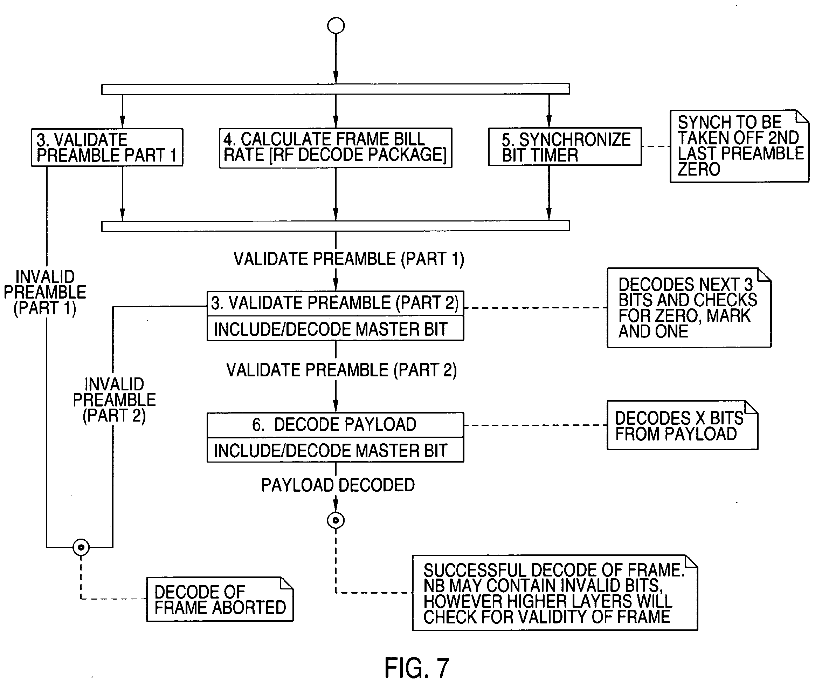

With attention directed to Figure 6, after the TPMS is activated, software in the TPMS processor causes the processor to (1) wait until a mark is detected. When a mark is detected, (2) measurement of maximum peak detect output (PDO) is started. Following mark detect, a stream of Manchester encoded payload data is sent to the TPMS processor and (3)-(6) decoding of the frame begins. The mark detect circuitry can be sensitive, so the preamble should be validated to ensure that it actually represents the start of a TPMS RF data frame. Therefore, as seen on Figure 7, frame decoding includes (3) validation of the preamble of the data frame. The first and second parts of the preamble are validated using different procedures and/or programmable boundary parameters.

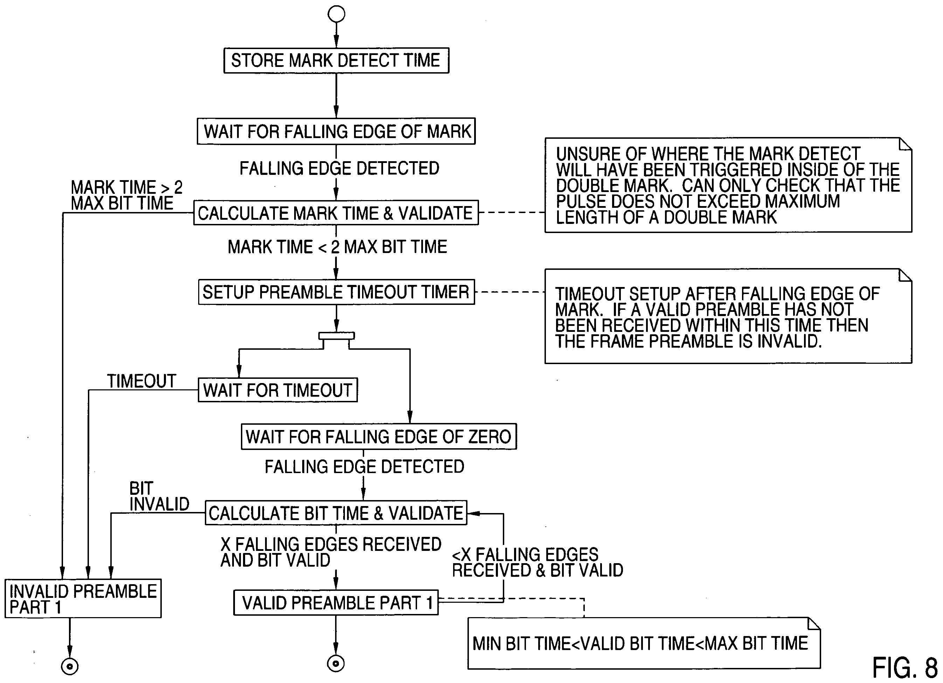

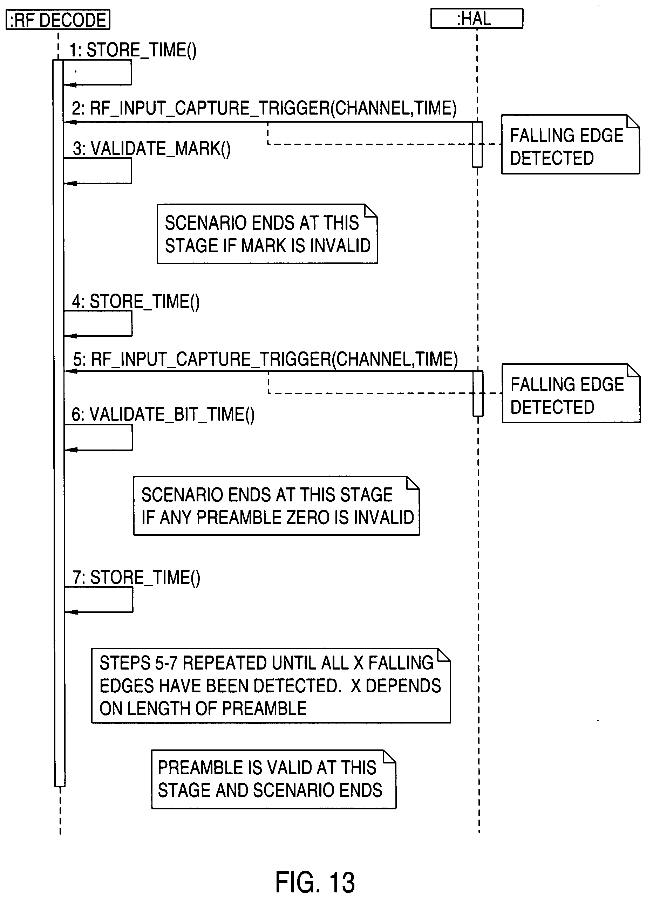

Referring to Figure 7, the mark detect circuitry will trigger at a position within the double mark that is not predictable. Consequently, a check can be made that validates the maximum pulse width. This procedure (validation of the first part of the preamble) is shown in Figures 8 and 13. The width of a double mark is expressed as follows:
DOUBLE MARK WIDTH < (2 * NOMINAL BIT WIDTH * TOLERANCE)

Transmitters in some different TPMSs use different protocols, but use the same carrier frequency, the same or similar data rate, and a similar frame preamble. Therefore, it is desirable to filter out signals from transmitters that do not use the specified system protocol because they are of no use to the subject system. Also, it is desirable to insure that there are only a specific number of zeros, or other indicator, appears in the preamble of the data frame.

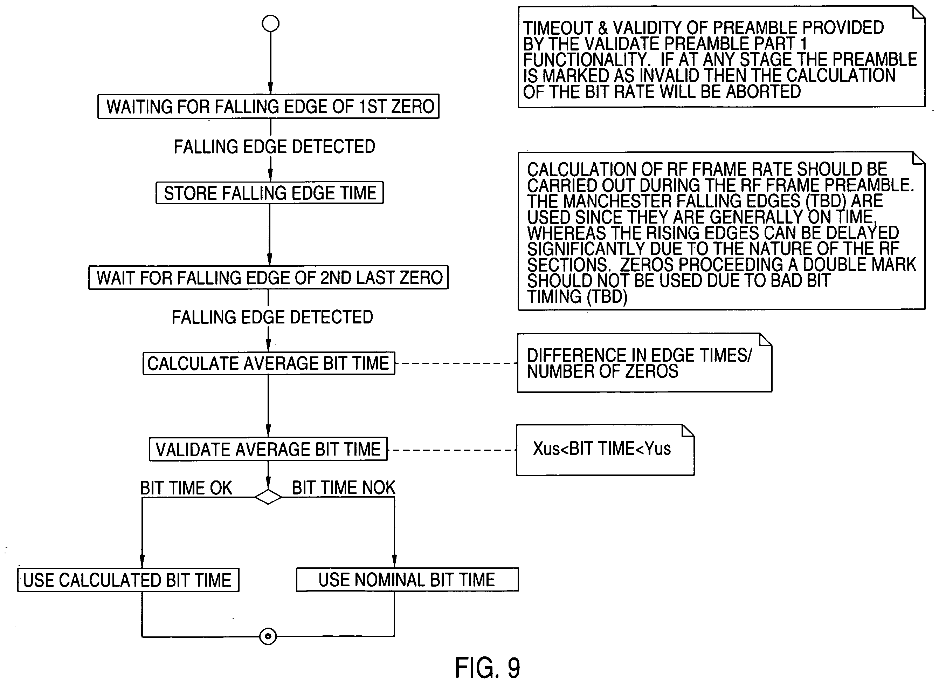

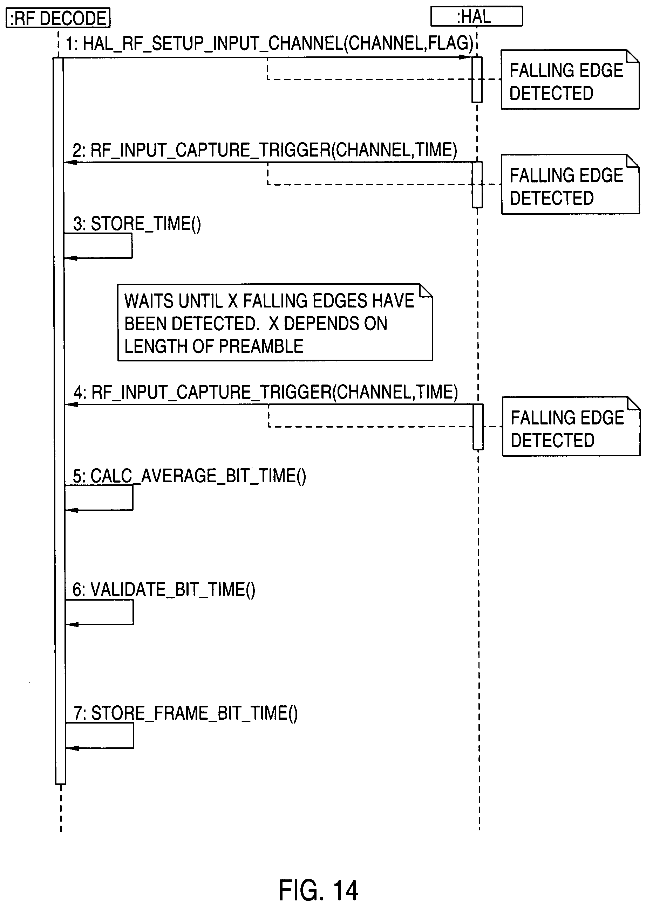

As shown in Figure 7, the bit timing of the zeros in the preamble may also be calculated and validated as part of the validation of the first part of the preamble. This is shown in Figures 9 and 14. The Bit Width = (nominal bit width ± tolerance). As seen in Figure 9, the average bit time (bit width) may be calculated by detecting the falling edges of the first zero and the second to last zero in the first part of the preamble. If the calculated average bit time is within tolerances (as established in the TPMS software), the calculated bit time may be used. Otherwise, the nominal bit time may be used.

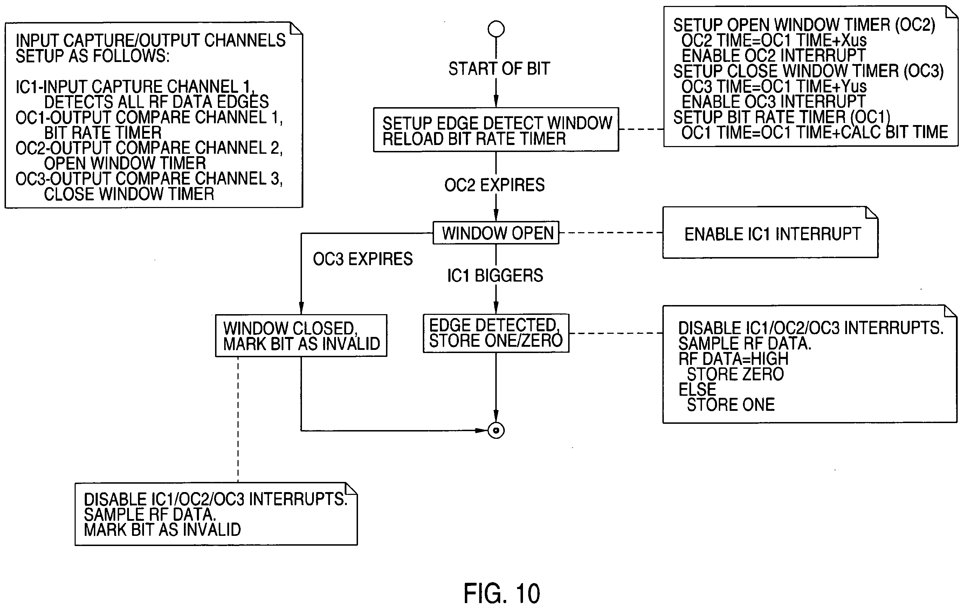

Looking at Figures 7 and 10, the second part of the preamble can be validated (3) by decoding the next three bits in the preamble as Manchester encoded bits and looking for a zero, mark and one. Decoding of Manchester encoded bits is described in more detail below. If either of the preamble validations fails, the preamble may be reported as being invalid.

Referring back to Figures 6 and 7, synchronization (5) of the bit timer used for transmitted and received data must be performed. Empirical data has showed that bit timing can be off significantly immediately after a large pulse, i.e. a double mark, zero, mark, one. Thus, synchronization may preferably be initiated on the falling edge of the second to last preamble zero as shown on Figure 9. This timer may indicate the start of a Manchester bit. To enable this timer to consistently activate in the correct place, the (4) bit rate of the incoming frame should be known. One example of a TPMS transmitter uses an RC oscillator for its timing so the bit rate will vary over temperature 4.096kHz ± 5%. However, because the length of a frame is short approx 16ms, the bit rate of the frame will be constant over the period of that frame, as the temperature cannot change significantly during in such a time frame.

As shown on Figures 8 and 13, the time between the falling edge of the first preamble zero and the falling edge of the fourth preamble zero is measured. The bit rate of the incoming frame can then be calculated down to an accuracy of 2-3us. However over the period of one frame (60+ bits), the bit timer will be significantly off time and so should be resynchronized periodically, as described below.

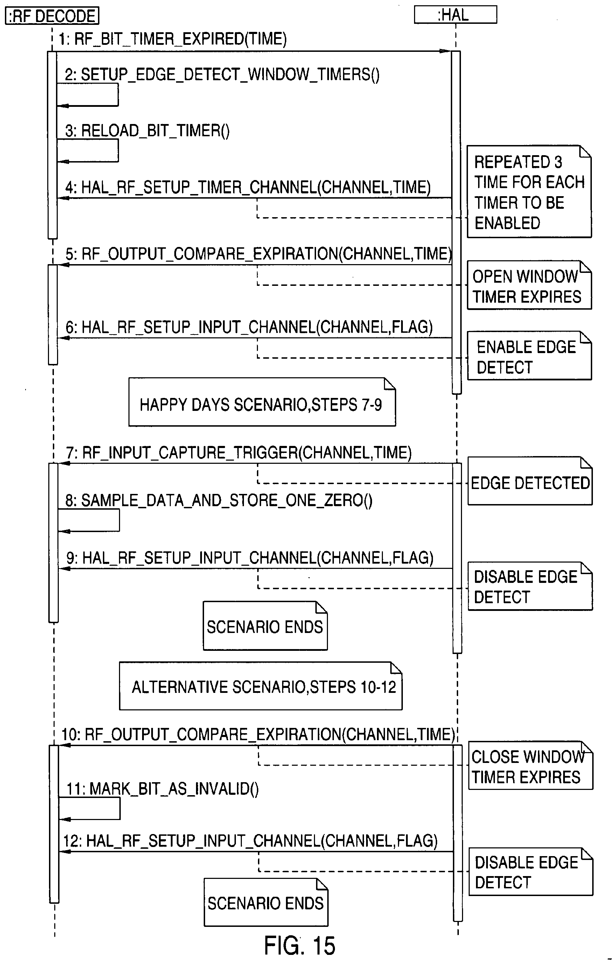

A characteristic of Manchester encoding is that a transition occurs in the middle of the bit. A rising edge corresponds to a Manchester Zero and a falling edge corresponds to a Manchester One. (Figure 4) To decode each Manchester bit, a window is preferably opened inside of the bit as described in Figures 10 and 15. Inside this window, edge detect is preferably enabled. Outside of this window, edge detect will preferably be disabled. This is illustrated in Figure 5. When an edge is detected inside of the window, the RF data line is sampled in accordance with embodiments of the present invention immediately after the edge to find out if the bit was a zero or one. If the window is closed without an edge occurring then the bit is preferably marked as invalid.

As noted above, the oscillator driving the bit timer in a TPMS system can drift and the bit time can only be calculated to a certain accuracy. Consequently, as seen on Figure 7, the bit timer is preferably resynchronized in (5) in accordance with the present invention. The bit timer can be resynchronized on receiving a valid edge by reloading the bit timer with half the calculated bit time. This will mean that for the next bit, the edge should occur in the middle of the bit, thereby keeping the bit timer in synchronization.

As seen on Figures 6 and 7, decoding of bits in a frame continues until the entire frame payload has been decoded. As seen on Figure 6, after a frame has been decoded, the (7) maximum PDO measurement is sampled and stored. This point represents an end of time-critical section of the RF decoding in the example TPMS receiver. The frame can now be (8) buffered and passed to a lower priority task as shown on Figure 6 and processing of buffered frames can now begin.

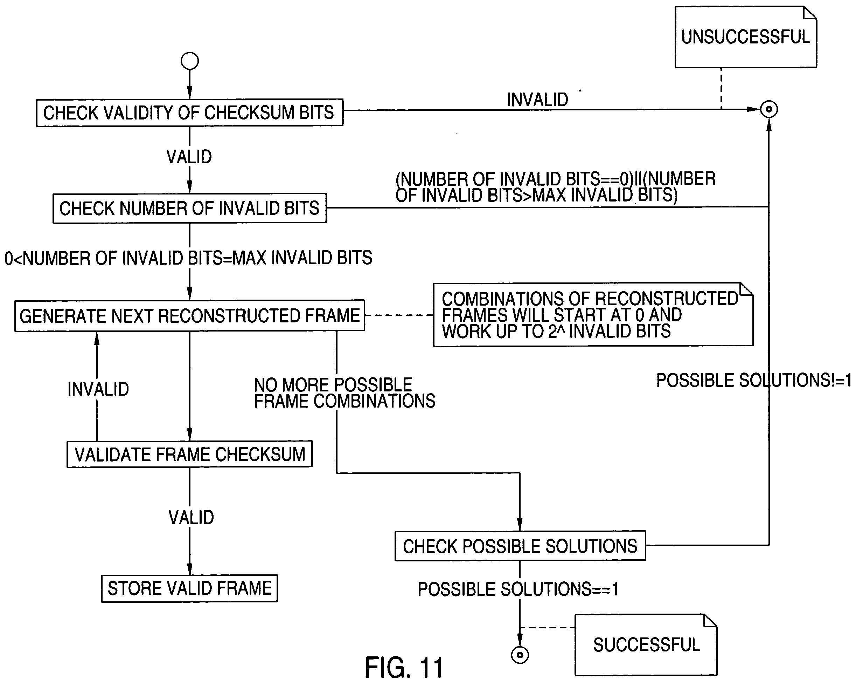

Processing of the buffered data frames includes attempts to reconstruct frames with any bits marked as invalid. These include frames initially determined (9) to have invalid checksums. If the frame is reconstructed and the frame checksum is successfully revalidated, the frame payload information is (10) extracted and stored. If frame reconstruction is not possible then the frame is discarded. The frame reconstruction procedure is shown on Figure 11. The frame checksum is calculated and any frames with invalid checksums are discarded. If the frame is not discarded, the information contained in the frame (transmitter ID, function code, pressure, temperature and checksum) is then stored in a system memory and a timer is started.

Still referring to Figure 11, during the frame decoding process, any bit where the TPMS processor did not detect any edges is marked as invalid. Frame reconstruction is processor intensive, so method embodiments of the present invention may filter-out as many invalid frames that are most likely beyond recovery as possible. These may include any frames with invalid bits in the checksum or any frames with an invalid bit count above a certain programmable threshold. In other words, a threshold may be provided in the TPMS software that defines the maximum allowable corruption in a frame. If the degree of frame corruption (i.e., number of invalid bits) exceeds this threshold, the frame may be discarded. Frame reconstruction may be performed by using a cyclic redundancy check algorithm if the like which may try every possible combination of binary code in the frame locations where decoded bits were marked as invalid and then recheck using programmable boundary parameters, such as the checksum or a checksum algorithm. If the checksum passes, then that frame is stored and the number of possible solutions is incremented. All possible frame combinations may be tested. If only one solution is found, then the frame may be considered successfully reconstructed and may be passed. If there are no solutions or if there is more than one possible solution then the frame may be considered to be unreconstructable and the frame may be discarded. During testing of an embodiment of the present method, the task times tabulated were measured for the frame processing with various levels of frame reconstruction enabled.

| **Max number of invalid bits** | **Task Time ms** |
|---|---|
| 0 | 0.16 |
| 1 | 0.7 |
| 2 | 0.8 |
| 3 | 1.1 |
| 4 | 1.8 |
| 5 | 3.3 |
| 6 | 6.6 |
| 7 | 15.2 |

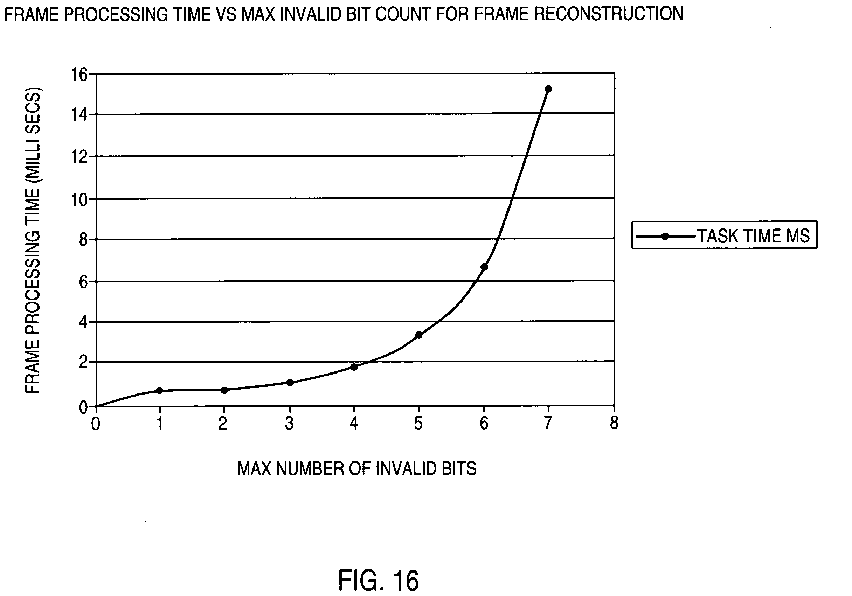

Figure 16 shows frame processing time as a function of the maximum number of invalid bits in the frame. In this example frames are received every 16ms. However, free processing time between frames is used to service other operating system tasks, so the maximum processing time for a frame is fixed at 2ms in this example. The maximum number of invalid bits in a frame to be reconstructed is set to four bits in the illustrated example. Accordingly, in a worst case scenario, with frames constantly incoming, all of which are invalid with four invalid bits, then 2ms/16ms or 12.5% of the processing power will be used up processing frames in this example.

As seen in Figure 6, frame decoding may continue until the end of the TPMS data block is reached. A TPMS data block may be transmitted over the period of one second. In other words, one second after the first data frame is received in the TPMS receiver, the block is complete. The data block can then be passed onto the rest of the TPMS application. Frames should be consistent within the same block, and a check is preferably made to ensure this. At the end of block processing, the average maximum PDO measurement is preferably calculated (11) and block processing may then be complete.

As one of ordinary skill in the art should appreciate in light of the foregoing description and accompanying Figures programming code can be written to implement embodiments of the present method. The programming language and the actual instructions used may depend on the TPMS processor used, the operating system, and on the preferences of the programmer.

As noted above, although embodiments of the various steps of the methods of the present invention have been described with respect to a remote tire pressure monitoring system, various embodiments of the present methods can be used with a variety of RF data link where improved data quality is an objective.

## Claims

1. A method for correcting errors in a block of digital data transmitted over a wireless link or channel being part of a Tire Pressure Monitoring System (TPMS), the data block comprising a plurality of transmitted data frames, and each data frame including at least one sequence of data bits, the method comprising:
a. identifying valid data frames and corrupted data frames by measuring a data corruption level for each transmitted data frame, wherein measuring the data corruption level comprises detecting a number and position of any invalid data bits or symbols in the transmitted data frame;
b. comparing the measured data corruption level for each corrupted data frame to a data corruption threshold;
c. reconstructing the corrupted data frames having a data corruption level below the data corruption threshold;
d. reconstructing the data block using data from valid and reconstructed data frames; and
e. verifying the data in the reconstructed data block.

2. The method of claim 1, wherein the data frames have checksums and said reconstructing corrupted data frames involves using a data determination algorithm to manipulate only detected data errors in a corrupted data frame while attempting to satisfy the checksum and subsequently storing any manipulated data frames that satisfy the checksum; and correcting the corrupted data frame only if exactly one manipulated data frame from the data determination algorithm satisfies the checksum.

3. The method of Claim 2 wherein the number of invalid data bits are detected using edge detection windows.

4. The method of Claim 3 wherein measuring the data corruption level further comprises time synchronizing the edge detection windows after detection of each data bit.

5. The method of claim 1, further comprising:
(a) detecting data errors in encoded data frames received over the wireless link, wherein the encoded data frames comprise symbols, by examining whether the symbols are received over finite time intervals;
(b) designating symbols not received over the finite time intervals as data errors;
(c) correcting the detected data errors that fall within a detected error threshold; and
(d) validating data frames containing corrected data errors by checking the corrected data frames against programmable boundary parameters.

6. The method of claim 5, wherein the symbols have a period, and wherein the finite time intervals have a duration of one symbol period.

7. The method of claim 5, wherein said detecting is accomplished by utilizing an edge detection window over the finite time interval.

8. The method of claim 7, wherein the edge detection window is resynchronized with the detection of every received symbol.

9. The method of claim 5, further comprising the symbols being Manchester encoded.

10. The method of claim 5, wherein each detected data error has a location in the received data frame and the location of the data error is stored in a memory.

11. The method of claim 10, wherein an error correction algorithm is used to correct the data errors, the number of iterations computed by the error correction algorithm is reduced by recalling the locations of the data errors and attempting to correct the data frame by changing only the known data errors so that iterations of the error correction algorithm involving changes to known correct data will not be attempted.

12. The method of claim 1 further comprising:
(a) detecting data errors in data frames received over the wireless channel, wherein the data frames comprise symbols, and wherein the data errors are detected by examining the presence of received symbols utilizing edge detection windows over finite time intervals;
(b) determining if the detected data errors are correctable and discarding the data frames that contain uncorrectable data errors;
(c) correcting detected data errors in the data frames containing correctable errors; and
(d) validating corrected data frames by checking corrected data frames against boundary thresholds.

13. The method of claim 12, wherein in said detecting, the data frames have checksums and said determining further comprises using a data determination algorithm to manipulate only the detected data errors in the data frame while attempting to satisfy the checksum and subsequently storing any manipulated data frames that satisfy the checksum, wherein the received data frame is correctable only if exactly one manipulated data frame from the data determination algorithm satisfies the checksum.

14. The method of claim 1 further comprising:
(a) receiving Manchester encoded data frames over the wireless link, wherein the data frames have checksums and are comprised of symbols, the symbols each having a symbol period;
(b) detecting errors in the received data frames by determining whether each symbol is present in the received data frame, wherein each data error has a location in the received data frame and the presence of each symbol is detected by utilizing edge detection windows having a duration of one symbol period, the symbols in the received data frame marked as data errors if the edge detection window closes without a symbol being detected;
(c) storing the location of each data error in a memory;
(d) discarding data frames if the number of data errors exceeds a programmable threshold level;
(e) determining if the data frames are correctable by utilizing a data correction algorithm,
wherein the data correction algorithm recalls and changes only the data errors in an attempt to satisfy the checksum so that the number of iterations used by the data correction algorithm in attempting to satisfy the checksum is reduced by not attempting iterations with changes to known good data, and wherein all modified data frames that satisfy the checksum are stored to the memory;
(f) correcting the received data frames if only exactly one modified data frame satisfies the checksum and discarding all other uncorrectable data frames; and
(g) validating the corrected data frames against programmable boundary thresholds.

15. The method of claim 14, wherein in said correcting discards the received data frames if the number of data errors exceeds four.

16. The method of claim 5, wherein said designating further comprises correcting detected errors by using a cyclic redundancy check algorithm.

17. The method of claim 13 or 14, wherein in said data correction or determination algorithm is a cyclic redundancy check algorithm.

18. The method of claim 5 or 14, wherein the method for detecting and correcting data errors is implemented in software.

## Patentansprüche

1. Verfahren zum Korrigieren von Fehlern in einem Block von digitalen Daten, die über eine(n) drahtlose(n) Verbindung oder Kanal als Teil eines Reifendrucküberwachungssystems (TPMS) übertragen werden, wobei der Datenblock eine Mehrzahl von übertragenen Daten-Frames umfasst und jeder Daten-Frame wenigstens eine Sequenz von Datenbits beinhaltet, wobei das Verfahren Folgendes beinhaltet:
a. Identifizieren gültiger Daten-Frames und beschädigter Daten-Frames durch Messen eines Datenbeschädigungsniveaus für jeden übertragenen Daten-Frame, wobei das Messen des Datenbeschädigungsniveaus das Erkennen einer Anzahl und Position ungültiger Datenbits oder Symbole im übertragenen Daten-Frame beinhaltet;
b. Vergleichen des gemessenen Datenbeschädigungsniveaus für jeden beschädigten Daten-Frame mit einer Datenbeschädigungsschwelle;
c. Rekonstruieren der beschädigten Daten-Frames mit einem Datenbeschädigungsniveau unter der Datenbeschädigungsschwelle;
d. Rekonstruieren des Datenblocks anhand von Daten von gültigen und rekonstruierten Daten-Frames; und
e. Verifizieren der Daten in dem rekonstruierten Datenblock.

2. Verfahren nach Anspruch 1, wobei die Daten-Frames Prüfsummen haben und das genannte Rekonstruieren von beschädigten Daten-Frames Folgendes beinhaltet:
Benutzen eines Datenbestimmungsalgorithmus zum Manipulieren nur von erkannten Datenfehlern in einem beschädigten Daten-Frame, während versucht wird, die Prüfsumme zu erfüllen und nachfolgend Speichern von manipulierten Daten-Frames, die die Prüfsumme erfüllen; und Korrigieren des beschädigten Daten-Frame nur dann, wenn genau ein manipulierter Daten-Frame vom Datenbestimmungsalgorithmus die Prüfsumme erfüllt.

3. Verfahren nach Anspruch 2, wobei die Anzahl ungültiger Datenbits mit Randerkennungsfenstern erkannt wird.

4. Verfahren nach Anspruch 3, wobei das Messen des Datenbeschädigungsniveaus ferner zeitliches Synchronisieren der Randerkennungsfenster nach dem Erkennen jedes Datenbits beinhaltet.

5. Verfahren nach Anspruch 1, das ferner Folgendes beinhaltet:
(a) Erkennen von Datenfehlern in über die drahtlose Verbindung empfangenen encodierten Daten-Frames, wobei die encodierten Daten-Frames Symbole umfassen, durch Untersuchen, ob die Symbole über finite Zeitintervalle empfangen werden;
(b) Designieren von nicht über die finiten Zeitintervalle empfangenen Symbolen als Datenfehler;
(c) Korrigieren der erkannten Datenfehler, die in eine erkannte Fehlerschwelle fallen; und
(d) Validieren von Daten-Frames, die korrigierte Datenfehler enthalten, durch Prüfen der korrigierten Daten-Frames anhand von programmierbaren Grenzparametern.

6. Verfahren nach Anspruch 5, wobei die Symbole eine Periode haben und wobei die finiten Zeitintervalle eine Dauer von einer Symbolperiode haben.

7. Verfahren nach Anspruch 5, wobei das genannte Erkennen durch Nutzen eines Randerkennungsfensters über das finite Zeitintervall erfolgt.

8. Verfahren nach Anspruch 7, wobei das Randerkennungsfenster mit der Erkennung jedes empfangenen Symbols resynchronisiert wird.

9. Verfahren nach Anspruch 5, das ferner das Manchester-Encodieren der Symbole beinhaltet.

10. Verfahren nach Anspruch 5, wobei jeder erkannte Datenfehler einen Ort in dem empfangenen Daten-Frame hat und der Ort des Datenfehlers in einem Speicher gespeichert wird.

11. Verfahren nach Anspruch 10, wobei ein Fehlerkorrekturalgorithmus zum Korrigieren der Datenfehler benutzt wird, die Anzahl von vom Fehlerkorrekturalgorithmus berechneten Iterationen durch Abrufen der Orte der Datenfehler und Versuchen reduziert wird, den Daten-Frame durch Ändern nur der bekannten Datenfehler zu korrigieren, so dass keine Iterationen des Fehlerkorrekturalgorithmus versucht werden, die Änderungen an bekannten korrekten Daten beinhalten.

12. Verfahren nach Anspruch 1, das ferner Folgendes beinhaltet:
(a) Erkennen von Datenfehlern in über den drahtlosen Kanal empfangenen Daten-Frames, wobei die Daten-Frames Symbole umfassen und wobei die Datenfehler durch Untersuchen der Anwesenheit von empfangenen Symbolen durch Benutzen von Randerkennungsfenstern über finite Zeitintervalle erkannt werden;
(b) Bestimmen, ob die erkannten Datenfehler korrigierbar sind, und Verwerfen der Daten-Frames, die unkorrigierbare Datenfehler enthalten;
(c) Korrigieren von erkannten Datenfehlern in den Daten-Frames, die korrigierbare Fehler enthalten; und
(d) Validieren von korrigierten Daten-Frames durch Prüfen von korrigierten Daten-Frames anhand von Grenzschwellen.

13. Verfahren nach Anspruch 12, wobei bei dem genannten Erkennen die Daten-Frames Prüfsummen haben und das genannte Bestimmen ferner Folgendes beinhaltet:
Benutzen eines Datenbestimmungsalgorithmus zum Manipulieren nur der erkannten Datenfehler in dem Daten-Frame, wobei versucht wird, die Prüfsumme zu erfüllen, und nachfolgend Speichern von manipulierten Daten-Frames, die die Prüfsumme erfüllen, wobei der empfangene Daten-Frame nur dann korrigierbar ist, wenn genau ein manipulierter Daten-Frame vom Datenbestimmungsalgorithmus die Prüfsumme erfüllt.

14. Verfahren nach Anspruch 1, das ferner Folgendes beinhaltet:
(a) Empfangen von Manchester-encodierten Daten-Frames über die drahtlose Verbindung, wobei die Daten-Frames Prüfsummen haben und aus Symbolen bestehen, wobei die Symbole jeweils eine Symbolperiode haben;
(b) Erkennen von Fehlern in den erkannten Daten-Frames durch Bestimmen, ob jedes Symbol in dem empfangenen Daten-Frame vorhanden ist, wobei jeder Datenfehler einen Ort in dem empfangenen Daten-Frame hat und die Anwesenheit jedes Symbols durch Benutzen von Randerkennungsfenstern mit einer Dauer von einer Symbolperiode erkannt wird, wobei die Symbole in dem empfangenen Daten-Frame dann als Datenfehler markiert werden, wenn das Randerkennungsfenster ohne ein erkanntes Symbol schließt;
(c) Speichern des Orts jedes Datenfehlers in einem Speicher;
(d) Verwerfen von Daten-Frames, wenn die Anzahl von Datenfehlern ein programmierbares Schwellenniveau übersteigt;
(e) Bestimmen, ob die Daten-Frames korrigierbar sind, durch Benutzen eines Datenkorrekturalgorithmus, wobei der Datenkorrekturalgorithmus nur die Datenfehler in einem Versuch abruft und ändert, um die Prüfsumme zu erfüllen, so dass die Anzahl von vom Datenkorrekturalgorithmus benutzten Iterationen in dem Versuch, die Prüfsumme zu erfüllen, durch Nichtversuchen von Iterationen mit Änderungen an bekannten guten Daten reduziert wird, und wobei alle modifizierten Daten-Frames, die die Prüfsumme erfüllen, im Speicher gespeichert werden;
(f) Korrigieren der empfangenen Daten-Frames, wenn nur genau ein modifizierter Daten-Frame die Prüfsumme erfüllt, und Verwerfen aller anderen unkorrigierbaren Daten-Frames; und
(g) Validieren der korrigierten Daten-Frames anhand von programmierbaren Grenzschwellen.

15. Verfahren nach Anspruch 14, wobei das genannte Korrigieren die empfangenen Daten-Frames verwirft, wenn die Anzahl von Datenfehlern vier übersteigt.

16. Verfahren nach Anspruch 5, wobei das genannte Designieren ferner das Korrigieren erkannter Fehler durch Benutzen eines zyklischen Redundanzprüfalgorithmus beinhaltet.

17. Verfahren nach Anspruch 13 oder 14, wobei der genannte Datenkorrektur- oder -bestimmungsalgorithmus ein zyklischer Redundanzprüfalgorithmus ist.

18. Verfahren nach Anspruch 5 oder 14, wobei das Verfahren zum Erkennen und Korrigieren von Datenfehlern in Software implementiert wird.

## Revendications

1. Un procédé de correction d'erreurs dans un bloc de données numériques transmis par l'intermédiaire d'un canal ou d'une liaison sans fil qui fait partie d'un système de surveillance de pression de pneu (TPMS), le bloc de données contenant une pluralité de trames de données transmises, et chaque trame de données contenant au moins une séquence de bits de données, le procédé comprenant :
a. l'identification de trames de données valides et de trames de données corrompues par la mesure d'un niveau de corruption de données pour chaque trame de données transmise, où la mesure du niveau de corruption de données comprend la détection d'un nombre et d'une position de tous bits de données ou symboles non valides dans la trame de données transmise,
b. la comparaison du niveau de corruption de données mesuré pour chaque trame de données corrompue à un seuil de corruption de données,
c. la reconstruction des trames de données corrompues possédant un niveau de corruption de données sous le seuil de corruption de données,
d. la reconstruction du bloc de données au moyen de données provenant de trames de données reconstruites et valides, et
e. la vérification des données dans le bloc de données reconstruit.

2. Le procédé selon la Revendication 1, où les trames de données possèdent des sommes de contrôle et ladite reconstruction de trames de données corrompues implique l'utilisation d'un algorithme de détermination de données destiné à la manipulation uniquement d'erreurs de données détectées dans une trame de données corrompue tout en cherchant à satisfaire la somme de contrôle, et subséquemment la conservation en mémoire de toutes trames de données manipulées qui satisfont la somme de contrôle, et la correction de la trame de données corrompue uniquement si exactement une trame de données manipulée provenant de l'algorithme de détermination de données satisfait la somme de contrôle.

3. Le procédé selon la Revendication 2 où le nombre de bits de données non valides est détecté au moyen de fenêtres de détection de contours.

4. Le procédé selon la Revendication 3 où la mesure du niveau de corruption de données comprend en outre une synchronisation temporelle des fenêtres de détection de contours après la détection de chaque bit de données.

5. Le procédé selon la Revendication 1, comprenant en outre :
(a) la détection d'erreurs de données dans des trames de données codées reçues par l'intermédiaire de la liaison sans fil, où les trames de données codées contiennent des symboles, par l'examen si les symboles sont reçus par l'intermédiaire d'intervalles temporels finis,
(b) la désignation de symboles non reçus par l'intermédiaire des intervalles temporels finis en tant qu'erreurs de données,
(c) la correction des erreurs de données détectées qui se situent à l'intérieur d'un seuil d'erreur détecté, et
(d) la validation de trames de données contenant des erreurs de données corrigées par la vérification des trames de données corrigées vis-à-vis de paramètres de limite programmables.

6. Le procédé selon la Revendication 5, où les symboles possèdent une période, et où les intervalles temporels finis possèdent un durée d'une période de symbole.

7. Le procédé selon la Revendication 5, où ladite détection est réalisée par l'utilisation d'une fenêtre de détection de contours sur l'intervalle temporel fini.

8. Le procédé selon la Revendication 7, où la fenêtre de détection de contours est resynchronisée avec la détection de chaque symbole reçu.

9. Le procédé selon la Revendication 5, comprenant en outre les symboles qui sont codés Manchester.

10. Le procédé selon la Revendication 5, où chaque erreur de données détectée possède un emplacement dans la trame de données reçue et l'emplacement de l'erreur de données est conservé en mémoire dans une mémoire.

11. Le procédé selon la Revendication 10, où un algorithme de correction d'erreurs est utilisé de façon à corriger les erreurs de données, le nombre d'itérations calculées par l'algorithme de correction d'erreurs est réduit par le rappel des emplacements des erreurs de données et la tentative de correction de la trame de données par la modification uniquement des erreurs de données connues de sorte que des itérations de l'algorithme de correction d'erreurs impliquant des modifications à des données correctes connues ne seront pas tentées.

12. Le procédé selon la Revendication 1 comprenant en outre :
(a) la détection d'erreurs de données dans des trames de données reçues par l'intermédiaire du canal sans fil, où les trames de données comprennent des symboles, et où les erreurs de données sont détectées par l'examen de la présence de symbole reçus au moyen de fenêtres de détection de contours sur des intervalles temporels finis,
(b) la détermination si les erreurs de données détectées peuvent être corrigées et le rejet des trames de données qui contiennent des erreurs de données qui ne peuvent pas être corrigées,
(c) la correction d'erreurs de données détectées dans les trames de données contenant des erreurs qui peuvent être corrigées, et
(d) la validation de trames de données corrigées par la vérification de trames de données corrigées vis-à-vis de seuils de limites.

13. Le procédé selon la Revendication 12, où, dans ladite détection, les trames de données possèdent des sommes de contrôle et ladite détermination comprend en outre l'utilisation d'un algorithme de détermination de données destiné à la manipulation uniquement des erreurs de données détectées dans la trame de données tout en cherchant à satisfaire la somme de contrôle, et subséquemment la conservation en mémoire de toutes trames de données manipulées qui satisfont la somme de contrôle, où la trame de données reçue peut être corrigée uniquement si exactement une trame de données manipulée provenant de l'algorithme de détermination de données satisfait la somme de contrôle.

14. Le procédé selon la Revendication 1 comprenant en outre :
(a) la réception de trames de données codées Manchester par l'intermédiaire de la liaison sans fil, où les trames de données possèdent des sommes de contrôle et sont composées de symboles, les symboles possédant chacun une période de symbole,
(b) la détection d'erreurs dans les trames de données reçues par la détermination si chaque symbole est présent dans la trame de données reçue, où chaque erreur de données possède un emplacement dans la trame de données reçue et la présence de chaque symbole est détectée par l'utilisation de fenêtres de détection de contours possédant une durée d'une période de symbole, les symboles dans la trame de données reçue étant marqués en tant qu'erreurs de données si la fenêtre de détection de contours se ferme sans qu'un symbole ne soit détecté,
(c) la conservation en mémoire de l'emplacement de chaque erreur de données dans une mémoire,
(d) le rejet de trames de données si le nombre d'erreurs de données dépasse un niveau seuil programmable,
(e) la détermination si les trames de données peuvent être corrigées par l'utilisation d'un algorithme de correction de données, où l'algorithme de correction de données rappelle et modifie uniquement les erreurs de données dans une tentative de satisfaire la somme de contrôle de sorte que le nombre d'itérations utilisées par l'algorithme de correction de données dans la tentative de satisfaire la somme de contrôle soit réduit par la non-tentative d'itérations avec des modifications à des données correctes connues, et où la totalité des trames de données modifiées qui satisfont la somme de contrôle sont conservées en mémoire dans la mémoire,
(f) la correction des trames de données reçues si uniquement exactement une trame de données modifiée satisfait la somme de contrôle et le rejet de la totalité des autres trames de données ne pouvant pas être corrigées, et
(g) la validation des trames de données corrigées vis-à-vis de seuils de limites programmables.

15. Le procédé selon la Revendication 14, où ladite correction rejette les trames de données reçues si le nombre d'erreurs de données dépasse quatre.

16. Le procédé selon la Revendication 5, où ladite désignation comprend en outre la correction d'erreurs détectées au moyen d'un algorithme de vérification de redondance cyclique.

17. Le procédé selon la Revendication 13 ou 14, où ledit algorithme de détermination ou de correction de données est un algorithme de vérification de redondance cyclique.

18. Le procédé selon la Revendication 5 ou 14, où le procédé de détection et de correction d'erreurs de données est mis en oeuvre dans un logiciel.
